**Europäisches Patentamt**

**European Patent Office**

**Office européen des brevets**

(19)

(11) Veröffentlichungsnummer: **0 203 409 B1**

# EUROPÄISCHE PATENTSCHRIFT

(12)

(45) Veröffentlichungstag der Patentschrift: **10.04.91**

(51) Int. Cl.5: **H03K 21/40, G06F 11/14**

(21) Anmeldenummer: **86106019.2**

(22) Anmeldetag: **02.05.86**

Die Akte enthält technische Angaben, die nach dem Eingang der Anmeldung eingereicht wurden und die nicht in dieser Patentschrift enthalten sind.

(54) **Verfahren und Anordnung zum nichtflüchtigen Speichern des Zählerstandes eines digitalen Zählers.**

(30) Priorität: **17.05.85 DE 3517865**

(43) Veröffentlichungstag der Anmeldung:
**03.12.86 Patentblatt 86/49**

(45) Bekanntmachung des Hinweises auf die Patenterteilung:
**10.04.91 Patentblatt 91/15**

(84) Benannte Vertragsstaaten:
**AT CH DE FR GB IT LI NL SE**

(56) Entgegenhaltungen:
**EP-A- 0 067 227**
**EP-A- 0 067 364**

(73) Patentinhaber: **Siemens Aktiengesellschaft**
**Wittelsbacherplatz 2**
**W-8000 München 2(DE)**

(72) Erfinder: **Pockrandt, Wolfgang, Dipl.-Phys.**
**Ilmstrasse 1**
**W-8069 Steinkirchen(DE)**

**Beschreibung**

Die Erfindung betrifft ein Verfahren und eine Anordnung, wie sie in den Oberbegriffen der Ansprüche 1 und 3 beschrieben sind.

Es gibt Anwendungen für digitale Zähler, beispielsweise als Kilometerzähler in einem Kraftfahrzeug, bei welchen die Notwendigkeit besteht, die Zählimpulse nichtflüchtig abzuspeichern, so daß bei Stromausfall der Zählerstand erhalten bleibt. Während des Abspeichervorgangs besteht jedoch die Gefahr, daß durch einen ungünstigen oder manipulierten Ausfall der Versorgungsspannung die bisher abgespeicherte Information unkontrolliert verändert wird. Durch Absichern des Programmiervorgangs über einen Stützkondensator läßt sich jedoch nur ein geringer Schutz, vor allem gegen Manipulationsversuche, erreichen.

Aus der EP-A 0067364 ist ein digitaler Zähler zum nichtflüchtigen Speichern des Zählerstandes bekannt. Dabei ist ein Datenspeicher mit zwei Adreßbereichen vorgesehen, in welchen abwechselnd der jeweils letzte Zählerstand eingeschrieben wird, wobei der vorhergehende Zählerstand gelöscht wird. Parallel dazu werden in einem Steuerspeicher vier Flagregister zur Markierung des Umprogrammierablaufs der Datenspeicherbereiche gesetzt. Anhand der logischen Zustände der Flags ist dann bei einem Abbruch der Umprogrammierung der Zählerstand rekonstruierbar.

In einem weiteren Ausführungsbeispiel dieser Veröffentlichung werden vier gleichwertige Zählerstandsspeicherstellen sowohl beim Beschreiben als auch beim Auslesen zyklisch durchlaufen. Dabei wird sichergestellt, daß mindestens der alte und der aktuelle Zählerstand in einer der Speicherstellen abgespeichert sind. Die beiden übrigen Speicherstellen dienen zur Aufnahme des folgenden Zählerstandes bzw. sind zum Umprogrammieren der Speicherstellen erforderlich.

Der Erfindung lag die Aufgabe zugrunde, ein Verfahren und eine Anordnung der oben genannten Art anzugeben, welche mit einer geringeren Anzahl von Speicherplätzen bzw. von Flagregistern betreibbar ist, also einen geringeren Hardwareaufwand erfordert.

Diese Aufgabe wird gemäß dem kennzeichnenden Teil des Anspruchs 1 gelöst.

Die Erfindung hat den Vorteil, daß aufgrund der geringeren Umprogrammiervorgänge die Arbeitsgeschwindigkeit erhöht ist.

Weiterbildungen der Erfindung ergeben sich aus den Unteransprüchen.

Im folgenden wird die Erfindung anhand eines Ausführungsbeispieles weiter beschrieben.

Fig. 1 zeigt ein Blockschaltbild der Erfindung.

Fig. 2 zeigt ein Ablaufdiagramm der Anordnung nach Fig. 1.

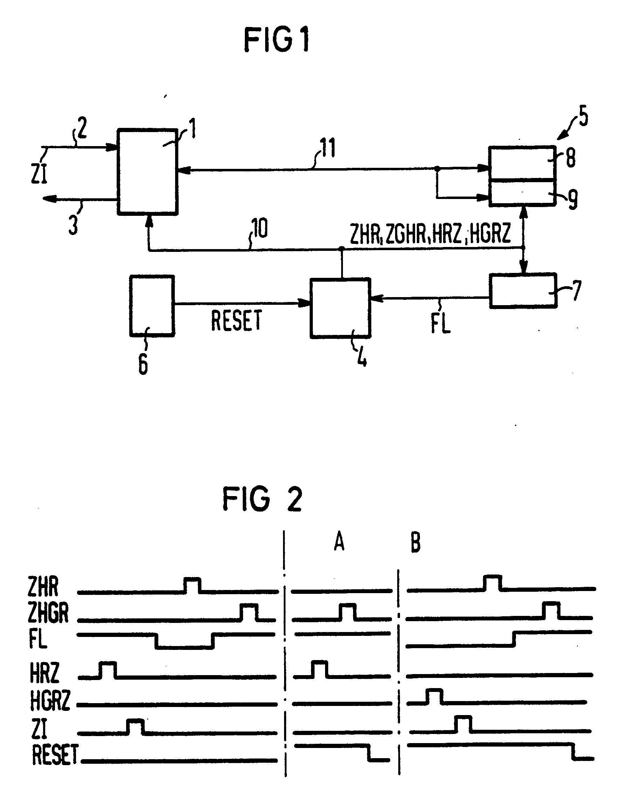

Die Anordnung nach Fig. 1 besteht aus einem digitalen Zähler 1, dessen Zählerstand aufgrund von Zählimpulsen ZI auf einer Eingangsleitung 2 inkrementiert wird. Am Ausgang 3 ist der aktuelle Zählerstand abgreifbar. Gesteuert von einer Ablaufsteuerung 4 ist der Zählerstand des Zählers 1 über einen Datenbus 11 in zwei voneinander unabhängige, nichtflüchtige Zählerstandsregister 5 übertragbar, die im folgenden als Haupt- bzw. Hintergrundregister 8, 9 bezeichnet werden. Umgekehrt kann auch der Inhalt der Zählerstandsregister 5 in den Zähler 1 zur Voreinstellung eines Zählerstandes eingeschrieben werden. Eine Sensorschaltung 6 erkennt einen Einbruch der Versorgungsspannung des Zählers 1 bzw. der gesamten Anordnung und liefert ein Abbruchsignal RESET an die Ablaufsteuerung 4. Ferner weist die Anordnung ein ebenfalls von der Ablaufsteuerung 4 setzbares Flagregister 7 auf. Durch das ebenfalls nichtflüchtige Flagregister 7 wird jeweils eine der Registeranordnungen 8 bzw. 9 markiert. Die Ansteuerung des Zählers 1, der Zählerstandsregister 5 und des Flagregisters 7 durch die Ablaufsteuerung 4 erfolgt über einen bidirektionalen Steuerbus 10. Erfolgt eine Zählanforderung, so läuft ein von der Ablaufsteuerung 4 gesteuerter Vorgang ab, der im folgenden zusammen mit dem Ablaufdiagramm der Fig. 2 beschrieben wird.

Durch ein Steuersignal HRZ wird der Inhalt des Hauptregisters 8 in den Zähler 1 übernommen. Bei einem ununterbrochenen Zählerbetrieb ist im Hauptregister 8 der letzte Zählerstand abgespeichert. Beim Eintreffen eines Zählimpulses ZI wird der Zählerstand erhöht. Durch ein Steuersignal an das Flagregister 7 wird dieses anschließend so programmiert, daß es das Hintergrundregister 9 markiert. Eine log. 1 des Flags FL weist in dem vorliegenden Beispiel auf das Hauptregister 8, während eine log. 0 das Hintergrundregister 9 bezeichnet.

Der nunmehr im Zähler 1 enthaltene aktuelle Zählerstand wird durch ein Steuersignal ZHR nichtflüchtig im Hauptregister 8 abgelegt. Durch den Pegelwechsel des Steuersignals FL wird das Flagregister 7 zur Markierung des Hauptregisters 8 programmiert. Anschließend wird durch ein Steuersignal ZHGR der Zählerstand im Hintergrundregister 9 abgespeichert.

Während des gesamten Ablaufs ist der Zähler 1 extern nicht beeinflußbar, da die Programmierspannung innerhalb der Anordnung erzeugt wird und der Programmiervorgang erst nach Erreichen eines vorgegebenen Programmierpegels beendet wird. Die Durchführung einer derartigen Maßname ist im einzelnen in der DE-A 28 28 855 beschrieben.

Sobald durch einen Spannungseinbruch vom Sensor 6 ein Signal RESET erzeugt ist, wird - abhängig vom Zeitpunkt des Auftretens des Unterbrechungssignals RESET - alternativ eine der folgenden Maßnahmen durchgeführt.

Ablauf A:
Das Unterbrechungssignal RESET wird erzeugt, nachdem der vorangegangene Zählvorgang regulär abgeschlossen wurde. Das Flag FL markiert also das Hauptregister 8. Die Ablaufsteuerung 4 erzeugt das Steuersignal HRZ und die im Hauptregister 8 gespeicherte Information wird in den Zähler 1 übernommen. Anschließend wird die Zählerinformation aufgrund des Steuersignals ZHGR im Hintergrundregister 9 abgespeichert.

Ablauf B:
Der vorhergehende Zählvorgang wurde irregulär beendet. Das Flag markiert somit das Hintergrundregister 9. Durch das Steuersignal HGRZ wird der Inhalt des Hintergrundregisters 9 in den Zähler I übernommen.

Dann wird der Zählerstand inkrementiert. Anschließend wird der neue Zählerstand im Hauptregister 8 abgespeichert (Steuersignal ZHR). Nachdem das Flag FL so programmiert ist, daß es auf das Hauptregister 8 zeigt, wird der neue Zählerstand in das Hintergrundregister 9 übernommen.

## Ansprüche

1. Verfahren zum nichtflüchtigen Speichern des Zählerstandes eines digitalen Zählers (1), wobei Speicherplätze (5, 7) zur Aufnahme von Zählerständen und von Zustandsinformationen des Zählablaufs vorhanden sind, **dadurch gekennzeichnet,** daß ein aktueller Zählerstand nacheinander in ein Hauptregister (8) und ein unabhängiges Hintergrundregister (9) abgespeichert wird, daß zuerst ein Register (8 bzw. 9), welches den vorhergehenden Zählerstand enthält, bis zum Abschluß der Zählerstandsübertragung in das andere Register (9 bzw. 8) markiert ist und anschließend das andere Register (9 bzw. 8) markiert wird, daß nach einer Spannungsunterbrechung der Inhalt des markierten Registers (8 bzw. 9) zur Voreinstellung in den Zähler übernommen und falls das Hintergrundregister (9) markiert ist, um 1 inkrementiert wird und daß der Zählerstand dann in das nach dieser Spannungsunterbrechung nicht markierte Register (9 bzw. 8) abgespeichert wird.

2. Verfahren nach Anspruch 1, **gekennzeichnet** durch folgende Verfahrensschritte:
   a) Übernahme des Inhalts des Hauptregisters (8) als Zählerstand in den Zähler (1).
   b) Inkrementieren des Zählers (1) bei Eintreffen eines Zählimpulses (ZI)
   c) Markieren des Hintergrundregisters (9)
   d) Übernahme des Zählerstandes in das Hauptregister (8)
   e) Markieren des Hauptregisters (8)
   f) Übernahme des Zählerstandes in das Hintergrundregister (9).

3. Verfahren nach Anspruch 1 oder 2, **gekennzeichnet** durch folgende Verfahrensschritte nach einem Abschluß des Zählvorganges, bei welchem das Hauptregister (8) markiert ist
   g) Übernahme des Hauptregisterinhalts in den Zähler (1)
   h) Abspeichern des Zählerstandes im Hintergrundregister (9).

4. Verfahren nach einem der vorhergehenden Ansprüche, **gekennzeichnet** durch folgende Verfahrensschritte nach einem irregulär beendeten Abschluß des Zählvorgangs, bei welchem das Hintergrundregister (9) markiert ist:
   i) Übernahme des Inhalts des Hintergrundregisters (9) in den Zähler (1)
   j) Inkrementieren des Zählerstandes
   k) Abspeichern des Zählerstandes im Hauptregister (8)
   l) Markieren des Hauptregisters
   m) Übernahme des Zählerstandes in das Hintergrundregister (9).

5. Anordnung zur Durchführung des Verfahrens nach Anspruch 1, **gekennzeichnet** durch eine, von einem Spannungssensor (6) beaufschlagte Ablaufsteuerung (4), zwei unabhängigen, nichtflüchtigen Zählerstandsregistern (5) und ein von der Ablaufsteuerung in Abhängigkeit vom jeweiligen Verfahrensschritt gesteuertes, ein Bit breites Flagregister (7).

## Claims

1. Method for the non-volatile storage of the counting state of a digital counter (1), memory locations (5, 7) being present for receiving counting states and state information on the counting process, characterised in that a current counting state is successively stored in a main register (8) and an independent backup register (9), in that firstly a register (8 or 9) which contains the previous counting state is marked until the termination of the counting state transmission into the other register (9 or 8) and then the other register (9 or 8) is marked, in that after a voltage cut-off the contents of the marked register (8 or 9) are transferred into the counter for presetting and, if the backup register (9) is marked, are incremented by one, and in that the counting state is then stored in the register (9 or 8) which is not marked after this voltage cut-off.

2. Method according to Claim 1, characterised by the following method steps:

a) Transfer of the contents of the main register (8) as counting state into the counter (1).

b) Incrementation of the counter (1) when a counting pulse (ZI) arrives

c) Marking of the backup register (9)

d) Transfer of the counting state into the main register (8)

e) Marking of the main register (8)

f) Transfer of the counting state into the backup register (9)

3. Method according to Claim 1 or 2, characterised by the following method steps, after a termination of the counting process in which the main register (8) is marked.

g) Transfer of the main register contents into the counter (1)

h) Storage of the counting state in the backup register (9).

4. Method according to one of the preceding claims, characterised by the following method steps after an irregularly concluded termination of the counting process in which the backup register (9) is marked:

i) Transfer of the contents of the backup register (9) into the counter (1)

j) Incrementation of the counting state

(k) Storage of the counting state in the main register (8)

l) Marking of the main register

m) Transfer of the counting state into the backup register (9).

5. Arrangement for carrying out the method according to Claim 1, characterised by a process control (4) triggered by a voltage sensor (6), by two independent, non-volatile counting state registers (5) and a one-bit wide flag register (7) controlled by the process control in dependence on the respective method step.

**Revendications**

1. Procédé pour la mémorisation non volatile de l'état de comptage d'un compteur numérique (1), des emplacements de mémoire (5,7) étant prévus pour la réception des états de comptage et des informations d'état du déroulement du comptage, caractérisé par le fait qu'un état actuel de comptage est mémorisé successivement dans un registre principal (8) et dans un registre auxiliaire indépendant (9), que tout d'abord un registre (8 ou 9), qui contient l'état de comptage précédent, est marqué dans l'autre registre (9 ou 8) jusqu'à la fin de la transmission de l'état de comptage et qu'ensuite l'autre registre (9 ou 8) est marqué, qu'après une interruption de tension, le contenu du registre marqué (8 ou 9) est transféré dans le compteur pour le préréglage et est incrémenté de 1 dans le cas où le registre auxiliaire (9) est marqué, et que l'état de comptage est alors mémorisé dans le registre (9 ou 8) non marqué après cette interruption de tension.

2. Procédé suivant la revendication 1, caractérisé par les étapes opératoires suivantes :

a) transfert du contenu du registre principal (8) en tant qu'état de comptage dans le compteur (1),

b) incrémentation du compteur (1) lors de l'arrivée d'une impulsion de comptage (ZI),

c) marquage du registre auxiliaire (9),

d) transfert de l'état de comptage dans le registre principal (8),

e) marquage du registre principal (8),

f) transfert de l'état de comptage dans le registre auxiliaire (9).

3. Procédé suivant la revendication 1 ou 2, caractérisé par les étapes opératoires suivantes, après la fin de l'opération de comptage, lors de laquelle le registre principal (8) est marqué,

g) transfert du contenu du registre principal dans le compteur (1),

h) mémorisation de l'état de comptage dans le registre auxiliaire (9).

4. Procédé suivant l'une des revendications précédentes, caractérisé par les étapes opératoires suivantes, après une fin, exécutée de façon irrégulière, de l'opération de comptage, lors de laquelle le registre auxiliaire (9) est marqué :

i) transfert du contenu du registre auxiliaire (9) dans le compteur (1),

j) incrémentation de l'état de comptage,

k) mémorisation de l'état de comptage dans le registre principal (8),

l) marquage du registre principal,

m) transfert de l'état de comptage dans le registre auxiliaire (9).

5. Dispositif pour la mise en oeuvre du procédé suivant la revendication 1, caractérisé par une unité de commande d'exécution (4) chargée par un détecteur de tension (6), par deux registres indépendants et non volatils (9) de l'état de comptage et par un registre de drapeaux (7) d'une largeur égale à un bit, commandé en fonction de l'étape opératoire respective.

# FIG 1

# FIG 2